# EUROPÄISCHE PATENTSCHRIFT

(11) **EP 2 700 166 B1**
(45) Veröffentlichungstag und Bekanntmachung des Hinweises auf die Patenterteilung: **06.11.2019**
(21) Anmeldenummer: 12714015.0
(22) Anmeldetag: 17.04.2012
(51) Int. Cl.: H03K 17/96, H03K 17/965

(54) **BEDIENVORRICHTUNG, INSBESONDERE FÜR EINE FAHRZEUGKOMPONENTE**
OPERATING DEVICE, IN PARTICULAR FOR A VEHICLE COMPONENT
DISPOSITIF DE COMMANDE, EN PARTICULIER POUR UN COMPOSANT DE VÉHICULE

(30) Priorität: 20.04.2011 DE 102011018269
(43) Veröffentlichungstag der Anmeldung: 26.02.2014
(73) Patentinhaber: Behr-Hella Thermocontrol GmbH, 70190 Stuttgart (DE)
(72) Erfinder: SIEBERT, Rainer, 59597 Erwitte (DE); STICH, Bernd, 33142 Büren (DE); KLEINE-HOLLENHORST, Holger, 59556 Lippstadt (DE)
(74) Vertreter: dompatent von Kreisler Selting Werner - Partnerschaft von Patent- und Rechtsanwälten mbB
(86) Internationale Anmeldenummer: PCT/EP2012/056962
(87) Internationale Veröffentlichungsnummer: WO 2012/143339

(56) Entgegenhaltungen:
- WO-A1-2007/014780
- WO-A1-2011/032898

## Beschreibung

Die Erfindung betrifft eine Bedienvorrichtung, insbesondere für eine Fahrzeugkomponente oder allgemein für ein Mensch-Maschine-Interface.

Für die verschiedensten elektrischen Geräte existieren Bedienvorrichtungen zur manuellen Einstellung und Veränderung der Betriebsparameter des Geräts. Insbesondere im Automotive-Bereich sowie beispielsweise auch bei anderen elektronischen Geräte (PDA, Handy, Tablet-Computer, Palmtops und Laptops) kann es von Vorteil sein, auf einer Anzeigevorrichtung ein beispielsweise Menü für die Einstellungsoptionen darzustellen, wenn sich der Bediener mit beispielsweise einem Finger seiner Hand der Bedienvorrichtung nähert. In diesem Zusammenhang ist es bekannt, kapazitive Näherungssensoren einzusetzen, die Elektroden aufweisen, welche der kapazitiven Erfassung eines sich beispielsweise einer Taste annähernden Objekts wie beispielsweise einer Hand oder eines Fingers einer Hand dienen. Die kapazitiv wirkende Elektrode eines derartigen Näherungssensors sollte möglichst nahe an der Vorderseite bzw. an der Vorderseite eines Tastenkörpers angeordnet sein, um die Annäherung eines Objekts zuverlässig erkennen zu können. Ein Beispiel für eine Betätigungstaste mit einem in dieser angeordneten kapazitiven Näherungssensor ist in DE-A-10 2006 035 837 beschrieben. Die Elektrode ist hierbei als Federelement ausgebildet, das an der Innenseite der vorderen Wand des Tastenkörpers anliegt. Beim Niederdrücken des Tastenkörpers muss also auch die Kraft des Federelements überwunden werden, was unweigerlich Einfluss auf die Haptik hat.

Weitere Beispiele für Bedienelemente mit Näherungssensorik, bei denen der Näherungssensor innerhalb eines niederdrückbaren Tastenkörpers angeordnet ist, finden sich in DE-A-10 2007 025 564 und EP-A-1 739 839. Auch bei den in diesen Schriften beschriebenen Beispielen wirkt sich die Sensorik auf die zum Niederdrücken der Tasten erforderliche Kraft aus. Zudem besteht eine weitere Schwierigkeit der bisher beschriebenen bekannten Tasten mit kapazitiver Näherungssensorik darin, dass eine Hinterleuchtung des Tastenkörpers bzw. von dessen Vorderwand nur noch eingeschränkt möglich ist, da diesbezüglich die Einbauten in Form der Näherungssensorik Einschränkungen bezüglich der gleichmäßigen Ausleuchtung des Tastenkörpers mit sich bringen.

Weitere Beispiele für Tasten mit Näherungssensorik sind in DE-A-10 2008 031 366, DE-A-34 29 338, DE-A-10 2005 025 021 und WO-A-2010/006 972 beschrieben.

Ferner ist es aus DE-U-20 2005 002 157 bekannt, bei einem von Hand bedienbaren, feststehenden Berührungsfeld (Touch-Screen oder -Panel) eine kapazitive Näherungssensorik dadurch zu realisieren, dass zwischen dem feststehenden Berührungsfeld und einer mit Abstand unterhalb des Berührungsfeldes angeordneten Trägerplatte eine sich zum Berührungsfeld hin aufweitende, schraubenförmige, elektrisch leitende Feder angeordnet ist, die unter Kompression zwischen dem Berührungsfeld und der Trägerplatte angeordnet ist und die kapazitive Elektrode des Näherungssensors bildet. Da das Berührungsfeld keinerlei Bewegungen vollführt, kann sich also die Feder auch nicht auf die Haptik auswirken.

Aus WO-A-2011/032898 ist eine Bedienvorrichtung mit kapazitiver Annäherungssensorik gemäß dem Oberbegriff des Patentanspruchs 1 bekannt. Die kapazitive Sensorik befindet sich dabei innerhalb des vom Tastenkörper eingenommenen Raums.

In WO-A-2007/014780 ist eine weitere Bedienvorrichtung mit kapazitiver Tastenannäherungssensorik beschrieben, wobei auch hier eine erste Gruppe von kapazitiven Elektroden innerhalb des Tastenkörpers und eine zweite Gruppe von Elektroden außerhalb des Führungselements für den Tastenkörper angeordnet sind.

Aufgabe der Erfindung ist es, eine Bedienvorrichtung insbesondere für eine Fahrzeugkomponente oder allgemein für ein Mensch-Maschine-Interface mit kapazitiver Näherungssensorik zu schaffen, wobei die kapazitive Näherungssensorik sich nicht auf die Haptik einer niederdrückbaren Taste der Bedienvorrichtung auswirkt.

Zur Lösung dieser Aufgabe wird mit der Erfindung eine Bedienvorrichtung, insbesondere für eine Fahrzeugkomponente oder allgemein für ein Mensch-Maschinen-Interface, vorgeschlagen, wobei die Bedienvorrichtung versehen ist mit den Merkmalen des Anspruchs 1. Einzelne Ausgestaltungen der Erfindung sind Gegenstand der Unteransprüche.

Die erfindungsgemäße Bedienvorrichtung umfasst mindestens eine Taste mit einem niederdrückbaren Tastenkörper. Dieser Tastenkörper ist zumindest teilweise innerhalb des Aufnahmeraums eines Führungselements der Bedienvorrichtung angeordnet, wobei der Tastenkörper beim Niederdrücken innerhalb des Aufnahmeraums geführt ist. Ferner weist die erfindungsgemäße Bedienvorrichtung einen kapazitiven Näherungssensor mit mindestens einer Elektrode zur Erfassung eines sich dem Tastenkörper annähernden Objekts auf. Bei diesem Objekt handelt es sich insbesondere um die Hand oder einen Finger der Hand einer die Bedienvorrichtung betätigenden Person.

Bei einer derartigen Bedienvorrichtung wird nun erfindungsgemäß die mindestens eine Elektrode außerhalb des Aufnahmeraums des Führungselements und damit auch außerhalb des Tastenkörpers angeordnet. Damit wird erreicht, dass die Elektrode keinerlei mechanischen o.dgl. Einflüssen bzw. Veränderungen unterliegt, wenn die Taste niedergedrückt wird. Damit sind die haptischen Eigenschaften der Taste nicht durch mechanische Komponenten der kapazitiven Näherungssensorik und deren Integration in beispielsweise die Bedienoberfläche der Bedienvorrichtung abhängig.

Erfindungsgemäß ist die Elektrode als Schraubenfeder, also als Federelement ausgebildet, durch die die Elektrode unter Spannung zwischen der Trägerplatte und einer Frontblende der Bedienvorrichtung angeordnet ist. Die Federvorspannung bewirkt hierbei die permanente elektrische Kontaktierung und mechanische Fixierung der Elektrode auch unter mechanischen Schwingungen und Erschütterungen, denen die Bedienvorrichtung ausgesetzt sein kann.

Die erfindungsgemäß vorgeschlagene Anordnung der Elektrode des kapazitiven Näherungssensors außerhalb des Aufnahmeraums des Führungselements bedeutet letztendlich, dass die Elektrode zwischen der dem Aufnahmeraum zugewandten Innenseite des Führungselements und dessen Außenseite, also beispielsweise in die Wand des Führungselements integriert ist, oder außerhalb des Führungselements sowie benachbart zu diesem und/oder angrenzend an dieses angeordnet ist, sich also außen um das Führungselement herum erstreckt.

In weiterer vorteilhafter Ausgestaltung der Erfindung kann vorgesehen sein, dass die Bedienvorrichtung mit einer eine Vorder- und eine Rückseite aufweisenden Frontblende versehen ist, die eine Aufnahmeöffnung für den Tastenkörper der mindestens einen Taste aufweist, wobei das Führungselement an der Rückseite der Frontblende von der Aufnahmeöffnung ausgehend über eine Länge absteht und die Elektrode sich über die Länge des Führungselements und insbesondere über dieses hinaus erstreckt.

Die Elektrode ist elektrisch mit einer Auswerteeinheit zur Ausgabe eines die Annäherung eines Objekts (einer Hand oder eines Fingers einer Hand) an den Tastenkörper anzeigenden Ausgangssignals verbunden. Hierzu kann die Elektrode beispielsweise ein Anschlussfeld einer Trägerplatte (insbesondere Platine) der Bedienvorrichtung kontaktieren.

Für die Umsetzung der Niederdrückbewegung der Taste in ein elektrisches (Schalt-)Signal steht der Tastenkörper mit einem Schalter in Wirkverbindung.

Der Schalter kann in den unterschiedlichsten Formen ausgeführt sein. So kann der Schalter beispielsweise in Form einer Schaltmatte, als Kurzhubschalter, als berührungslos ansprechender Schalter o.dgl. ausgeführt sein.

Die Erfindung wird nachfolgend anhand eines Ausführungsbeispiels und unter Bezugnahme auf die Zeichnung, in der ein Schnitt durch eine Taste einer Bedienvorrichtung gezeigt ist, näher erläutert.

Die Erfindung wird nachfolgend anhand zweier Ausführungsbeispiele und unter Bezugnahme auf die Zeichnung näher erläutert. Im Einzelnen zeigen dabei:
- Fig. 1: einen Schnitt durch eine Taste einer Bedienvorrichtung gemäß einem ersten Ausführungsbeispiel und
- Fig. 2: einen Schnitt durch zwei nebeneinander angeordnete Tasten einer Bedienvorrichtung gemäß einem zweiten Ausführungsbeispiel.

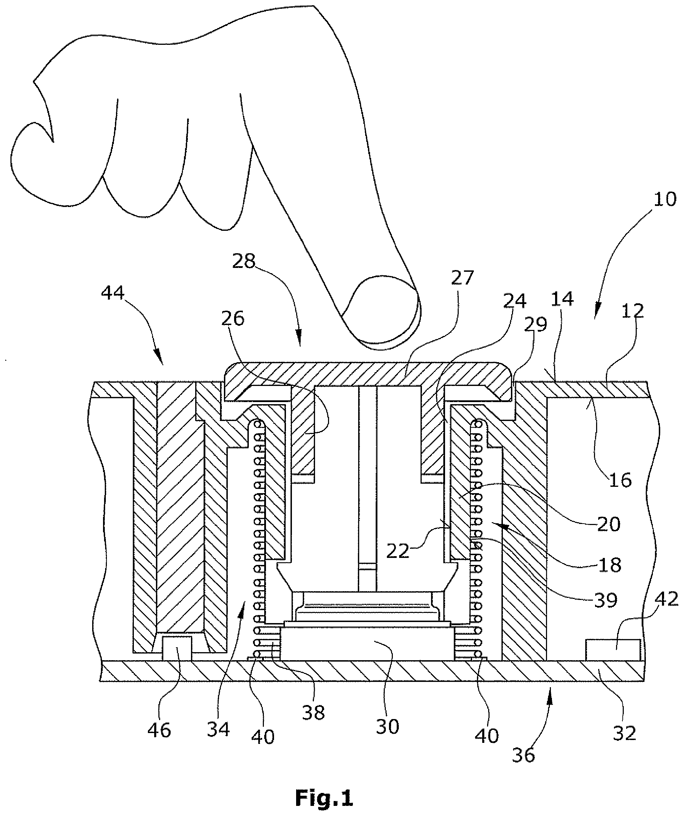

In Fig. 1 ist der für die Erfindung interessierende Teil einer Bedienvorrichtung 10 dargestellt. Die Bedienvorrichtung 10 weist eine Frontblende oder Abdeckung 12 auf, die eine Vorderseite 14 und eine Rückseite 16 aufweist. Von der Rückseite 16 steht ein Führungselement 18 ab, das beispielsweise eine umlaufende Wand 20 aufweist. Die Innenseite 22 der Wand 20 des Führungselements 18 bildet einen Aufnahmeraum 24 für den Tastenkörper 26 mit einer Vorderwand 27 einer niederdrückbaren Taste 28. Die Taste 28 bzw. ihre Vorderwand 27 befindet sich in einer Aufnahmeöffnung 29 in der Frontblende bzw. Abdeckung 12. Der Tastenkörper 26 ist in dem Aufnahmeraum 24 des Führungselements 18 geführt und ist niederdrückbar, wobei er in Wirkverbindung mit einem Schalter 30 steht, der auf einer der Rückseite 16 der Frontblende 12 zugewandten Trägerplatte 32 angeordnet ist.

Um das Führungselement 18 herum erstreckt sich eine Elektrode 34, die Teil eines kapazitiven Näherungssensors 36 ist. Die Elektrode 34 ist als schraubenförmige elektrisch leitende Feder 38 ausgeführt, die sich zwischen der Rückseite 16 der Frontblende 12 und der Trägerplatte 32 abstützt und das Führungselement 18 an seiner Außenseite 39 umgibt. Auf der Trägerplatte 32 befindet sich ein beispielsweise ringförmiges Kontaktfeld 40, an dem die elektrisch leitende Feder 38 anliegt. Das Kontaktfeld 40 steht über eine nicht dargestellte Leiterbahn in elektrischer Verbindung mit einer Auswerteeinheit 42 des kapazitiven Näherungssensors 36 zur Ausgabe eines die Annäherung eines Objekts an den Tastenkörper 26 anzeigenden Ausgangssignals.

Ferner weist die Bedienvorrichtung 10 eine der Taste 28 zugeordnete Funktionsrückmeldeanzeige 44 auf, über die mit Hilfe einer Lichtquelle 46 die Betätigung der Taste 28 und damit die Aktivierung der über die Taste 28 auswählbaren Funktion angezeigt wird.

Wie sich aus dem zuvor Beschriebenen sowie aus Fig. 1 ergibt, erfolgt die kapazitive Sensierung beispielsweise einer Hand oder eines Fingers einer Hand über die außerhalb sowohl des Tastenkörpers 26 als auch des Führungselements 18 angeordnete Elektrode 34 und damit über eine außerhalb der Tastenführung vorgesehene Signalübertragung mit Hilfe einer elektrisch leitenden metallischen Feder oder mit Hilfe eines teilweise oder vollständig metallisierten und federvorgespannten Kunststoffkörpers oder mit Hilfe eines metallischen Stanzbiegeteils mit Federvorspannung. Die Federvorspannung bewirkt dabei die permanente elektrische Kontaktierung und mechanische Fixierung der Elektrode 34 auch bei mechanischen Erschütterungen bzw. Schwingungen. Wahlweise kann die elektrisch leitfähige partielle Metallsierung des Führungselements 18 auch durch partielles Aufbringen von leitfähigen Polymersubstanzen auf dem vorzugsweise aus Kunststoff gefertigten Führungselement 18 erzielt werden. Die mechanische Kontaktierung der Elektrode 34 an der Frontblende 12 erfolgt durch Anlage der Elektrode 34 an der Rückseite 16 der Frontblende 12, während die elektrische und mechanische Kontaktierung der Elektrode zur Trägerplatte 32 hin über das Kontaktfeld 40 in Form beispielsweise eines Karbon-, Gold- oder metallischen Pad oder ähnliches erfolgt. Die elektrische Kontaktierung der Elektrode 34 (insbesondere Feder 38) auf der Trägerplatte 32 kann vollflächig oder partiell sein. Im Falle der Verwendung von Schaltmatten wird die Kontaktierung der Elektrode 34 durch partielle Öffnungen (an einer, zwei oder mehreren Positionen) der Schaltmatte, durch die sich die Elektrode 34 bis zur Trägerplatte 32 hindurch erstreckt, realisiert. Die Vorderwand 27 des Tastenkörpers 26 sollte das Führungselement 18 und die Elektrode 34 seitlich nach außen überdecken.

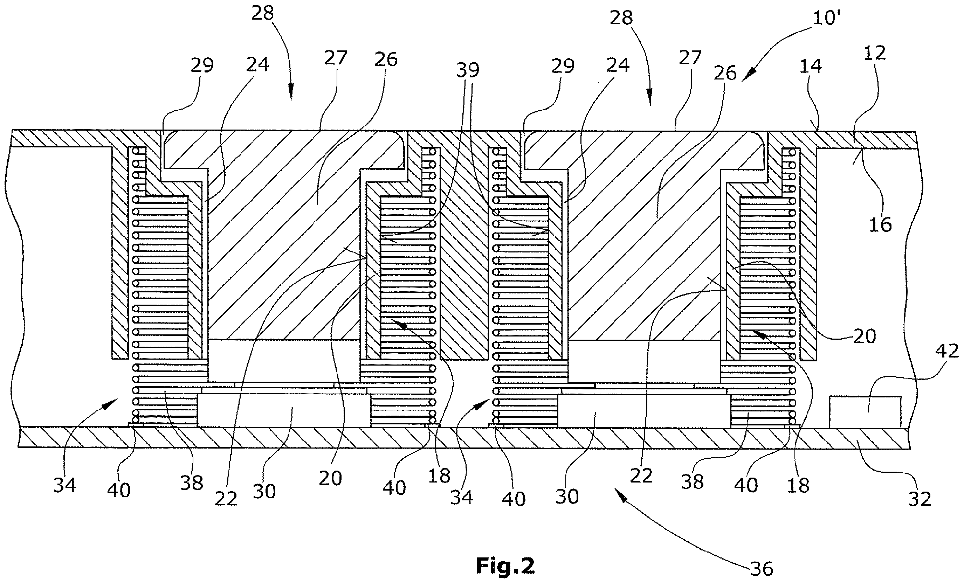

In Fig. 2 ist ein Längsschnitt durch zwei nebeneinanderliegende Tasten 28 einer alternativ ausgebildeten Bedienvorrichtung 10' dargestellt. Soweit die Einzelbestandteile dieser Bedienvorrichtung 10' funktionsgleich bzw. identisch mit den Einzelbestandteilen der Bedienvorrichtung 10 gemäß Fig. 1 sind, sind sie in Fig. 2 mit den gleichen Bezugszeichen versehen.

Ein Unterschied zwischen den Bedienvorrichtungen 10 und 10' ist darin zu sehen, dass bei der Bedienvorrichtung 10' gemäß Fig. 2 die wiederum beispielhaft als Schraubenfeder 38 ausgeführte Elektrode des jeder Taste 28 zugeordneten Näherungssensors 36 außerhalb des von der Taste 28 bzw. dessen Tastenkörper 26 eingenommenen Bereichs angeordnet ist. Im Übrigen werden bei dem Ausführungsbeispiel gemäß Fig. 2 die gleichen Vorteile genutzt wie bei der Bedienvorrichtung 10 gemäß Fig. 1.

### BEZUGSZEICHENLISTE

- 10: Bedienvorrichtung
- 10': Bedienvorrichtung
- 12: Frontblende der Bedienvorrichtung
- 14: Vorderseite der Frontblende
- 16: Rückseite der Frontblende
- 18: Führungselement
- 20: Wand des Führungselements
- 22: Innenseite des Aufnahmeraums
- 24: Aufnahmeraum im Führungselement
- 26: Tastenkörper der Taste
- 27: Vorderwand des Tastenkörpers
- 28: Taste
- 29: Aufnahmeöffnung in der Frontblende
- 30: Schalter
- 32: Trägerplatte
- 34: Elektrode des Näherungssensors
- 36: Näherungssensor
- 38: Schraubenfeder
- 39: Außenseite des Führungselements
- 40: Kontaktfeld auf der Trägerplatte
- 42: Auswerteeinheit
- 44: Funktionsrückmeldeanzeige
- 46: Lichtquelle der Funktionsrückmeldeanzeige

## Patentansprüche

1. Bedienvorrichtung, insbesondere für eine Fahrzeugkomponente oder allgemein für ein Mensch-Maschinen-Interface, mit
- einer Frontblende (12) mit einer Vorderseite (14) und einer Rückseite (16),
- mindestens einer Taste (28), die einen von der Vorderseite (14) der Frontblende (12) aus niederdrückbaren Tastenkörper (26) aufweist,
- einem an und/oder hinter der Rückseite (16) der Frontblende (12) angeordnetem Führungselement (18), das einen Aufnahmeraum (24) definiert und eine dem Aufnahmeraum (24) zugewandte Innenseite (22) sowie eine dem Aufnahmeraum (24) abgewandte Außenseite (39) aufweist, wobei der Tastenkörper (26) in dem Aufnahmeraum (24) geführt und zumindest teilweise von dem Aufnahmeraum (24) aufgenommen ist, und
- einem kapazitiven Näherungssensor (36) mit einer an und/oder hinter der Rückseite (16) der Frontblende (12) angeordneten Elektrode (34) zur Erfassung eines sich dem Tastenkörper (26) annähernden Objekts, insbesondere einer Hand oder eines Finger einer Hand,
- einer Trägerplatte (32), auf der zumindest ein mit dem Tastenkörper (26) in Wirkverbindung stehender Schalter (30) angeordnet ist,
**dadurch gekennzeichnet,**
- **dass** die Elektrode (34) außerhalb des Aufnahmeraums (24) des Führungselements (18) angeordnet ist, indem die Elektrode (34) zwischen der Innenseite (22) und der Außenseite (39) des Führungselements (18) angeordnet ist oder sich außen um das Führungslement (18) herum erstreckt und damit außerhalb des Führungselements (18) sowie benachbart zu dem Führungselement (18) und/oder angrenzend an das Führungselement (18) angeordnet ist,
- **dass** das Führungselement (18) an der Rückseite (16) der Frontblende (12) von der Aufnahmeöffnung ausgehend über eine Länge absteht,
- **dass** auf der Trägerplatte (32) ein Kontaktfeld (40) zur elektrischen Kontaktierung der Elektrode (34) ausgebildet ist und
- **dass** die Elektrode (34) als Schraubenfeder (38) ausgebildet ist, die sich zwischen dem Kontaktfeld (40) der Trägerplatte (32) und dem der Frontblende (12) zugewandten Ende des Führungselements (18) erstreckt.

2. Bedienvorrichtung nach Anspruch 1, **dadurch gekennzeichnet, dass** die Frontblende (12) eine Aufnahmeöffnung (29) für den Tastenkörper (26) der mindestens einen Taste (28) aufweist.

3. Bedienvorrichtung nach Anspruch 1 oder 2, **dadurch gekennzeichnet, dass** die Elektrode (34) sich über die Länge des Führungselements (18) und insbesondere über dieses hinaus erstreckt.

4. Bedienvorrichtung nach einem der Ansprüche 1 bis 3, **gekennzeichnet durch** eine mit der Elektrode (34) gekoppelte Auswerteeinheit (42) zur Ausgabe eines die Annäherung des Objekts an den Tastenkörper (26) anzeigenden Ausgangssignals.

## Claims

1. An operating device, in particular for a vehicle component or generally for a human/machine interface, comprising
- a front panel (12) having a front side (14) and a rear side (16),
- at least one pushbutton (28) having a pushbutton body (26) depressible from the front side (14) of the front panel (12),
- a guide element (18) arranged on and/or behind the rear side (16) of the front panel (12) defining an accommodating area (24) and comprising an inner side (22) facing towards the accommodating area (24) and an outer side (39) facing away from the accommodating area (24), the pushbutton body (26) being guided in the accommodating area (24) and being at least partially accommodated by the accommodation area (34), and
- a capacitive proximity sensor (36) comprising an electrode (34) arranged on and/or behind the rear side (16) of the front panel (12), for detecting an object approaching the pushbutton body (26), in particular a hand or a finger of a hand,
- a support plate (32) having arranged or formed thereon at least one switch (30) operatively connected to the pushbutton body (26),
**characterized in**
- **that** the electrode (34) is arranged outside the accommodating area (24) of the guide element (18) in that electrode (34) is arranged between the inner side (22) and the outer side (39) of the guide element (18) or extends externally around the guide element (18) and thus outside the guide element (18) as well as adjacent to the guide element (18) and/or adjoining to the guide element (18),
- **that** at the rear side (16) of the front panel (12), the guide element (18) projects from said accommodating opening by a length,
- **that** a contact field (40) for electrically contacting the electrode (34) is formed on the support plate (32), and
- **that** the electrode (34) is formed as a helical spring (38) that extends between the contact field (40) of the support plate (32) and the end of the guide element (18) that faces to the front panel (12).

2. The operating device according to claim 1, **characterized in that** the front panel (12) comprises an accommodating opening (29) for the pushbutton body (26) of said at least one pushbutton (28).

3. The operating device according to claim 1 or 2, **characterized in that** the electrode (34) extends all the way along the length of the guide element (18) and preferably beyond the guide element.

4. The operating device according to any one of claims 1 to 3, **characterized by** an evaluation unit (42) coupled to the electrode (34), for outputting an output signal indicating the approach of said object to the pushbutton body (26).

## Revendications

1. Dispositif de commande, destiné en particulier à un composant de véhicule ou généralement à une interface homme-machine, le dispositif de commande comprenant
- un panneau avant (12) pourvu d'un côté avant (14) et d'un côté arrière (16),
- au moins une touche (28) qui comporte un corps de touche (26) pouvant être enfoncé depuis le côté avant (14) du panneau avant (12),
- un élément de guidage (18) qui est disposé sur au niveau et/ou en arrière du côté arrière (16) du panneau avant (12) définissant un espace de réception (24), et qui comporte un côté intérieur (22) faisant face à l'espace de réception (24) et un côté extérieur (39) opposé à l'espace de réception (24), le corps de touche (26) étant guidé dans l'espace de réception (24) et étant au moins partiellement reçu par l'espace de réception (24), et
- un capteur de proximité capacitif (36) comportant une électrode (34) qui est disposée au niveau de et/ou en arrière du côté arrière (16) du panneau avant (12) et qui est destinée à détecter un objet s'approchant du corps de touche (26), en particulier une main ou un doigt d'une main,
- une plaque de support (32) sur laquelle est disposé au moins un commutateur (30) relié fonctionnellement au corps de touche (26),
**caractérisé en ce que**
- l'électrode (34) est disposée à l'extérieur de l'espace de réception (24) de l'élément de guidage (18) du fait que l'électrode (34) est disposée entre le côté intérieur (22) et le côté extérieur (39) de l'élément de guidage (18) ou s'étend à l'extérieur autour de l'élément de guidage (18) et est donc disposée à l'extérieur de l'élément de guidage (18) et au voisinage de l'élément de guidage (18) et/ou de manière adjacente à l'élément de guidage (18),
- l'élément de guidage (18) dépasse de l'ouverture de réception sur une certaine longueur du côté arrière (16) du panneau avant (12),
- une zone de contact (40) est formée sur la plaque de support (32) de façon à venir électriquement en contact avec l'électrode (34) et
- l'électrode (34) est conçue comme un ressort hélicoïdal (38) qui s'étend entre la zone de contact (40) de la plaque de support (32) et l'extrémité de l'élément de guidage (18) qui fait face au panneau avant (12).

2. Dispositif de commande selon la revendication 1, **caractérisé en ce que** le panneau avant (12) comporte une ouverture de réception (29) destinée au corps de touche (26) de l'au moins une touche (28).

3. Dispositif de commande selon la revendication 1 ou 2, **caractérisé en ce que** l'électrode (34) s'étend sur la longueur de l'élément de guidage (18) et en particulier au-delà de celui-ci.

4. Dispositif de commande selon l'une des revendications 1 à 3, **caractérisé par** une unité d'évaluation (42) couplée à l'électrode (34) et destinée à délivrer un signal de sortie indiquant que l'objet approche du corps de touche (26).
